(19) Europäisches Patentamt
European Patent Office
Office européen des brevets

(11) **EP 2 191 606 B1**

(12) **EUROPÄISCHE PATENTSCHRIFT**

(45) Veröffentlichungstag und Bekanntmachung des Hinweises auf die Patenterteilung:
**30.04.2014 Patentblatt 2014/18**

(51) Int Cl.:
*H04L 1/20* (2006.01)  *G01R 31/317* (2006.01)
*H04L 7/033* (2006.01)  *H03L 7/06* (2006.01)

(21) Anmeldenummer: **08802411.2**

(22) Anmeldetag: **19.09.2008**

(86) Internationale Anmeldenummer:
**PCT/EP2008/007904**

(87) Internationale Veröffentlichungsnummer:
**WO 2009/040060 (02.04.2009 Gazette 2009/14)**

(54) **VERFAHREN UND VORRICHTUNG ZUR AUFZEICHNUNG VON JITTERDATEN**

METHOD AND DEVICE FOR RECORDING JITTER DATA

PROCÉDÉ ET DISPOSITIF D'ENREGISTREMENT DE DONNÉES RELATIVES À LA GIGUE

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität: **21.09.2007 DE 102007045085**

(43) Veröffentlichungstag der Anmeldung:
**02.06.2010 Patentblatt 2010/22**

(73) Patentinhaber: **Rohde & Schwarz GmbH & Co. KG 81671 München (DE)**

(72) Erfinder:
• **VILLARINO VILLA, Ruben**
  **80333 München (DE)**
• **KUHWALD, Thomas**
  **85570 Markt Schwaben (DE)**

(74) Vertreter: **Körfer, Thomas et al**
  **Mitscherlich PartmbB**
  **Patent- und Rechtsanwälte**
  **Postfach 33 06 09**
  **80066 München (DE)**

(56) Entgegenhaltungen:
EP-A- 0 312 671        EP-A- 0 912 010
EP-A- 1 152 562        WO-A-2007/059409
US-A- 4 771 250        US-A- 5 469 466
US-A1- 2004 136 450    US-A1- 2005 144 416

• GIOVANNI DE MICHELI ET AL: "Hardware/ Software Co-Design", PROCEEDINGS OF THE IEEE, IEEE. NEW YORK, US, vol. 85, no. 3, 1 March 1997 (1997-03-01), XP011043815, ISSN: 0018-9219

**Beschreibung**

Die Erfindung bezieht sich auf ein Verfahren und eine Vorrichtung zur Aufzeichnung des Signalverlaufs eines binären Datenstroms nebst Taktinformation, insbesondere von Jitterdaten.

TECHNISCHER HINTERGRUND UND STAND DER TECHNIK

In der digitalen Übertragungstechnik und insbesondere bei der seriellen Datenübertragung werden Daten bitweise hintereinander über ein bestimmtes Medium übertragen. Das der Übertragung unterliegende Taktsignal wird über eine zusätzliche Leitung bereitgestellt oder ist durch gezielte Symbolkodierung bereits im Datenstrom eingebettet. Im letzten Fall sorgt eine Taktrückgewinnungsvorrichtung (englisch: Clock Data Recovery oder CDR) im Empfänger für die Ermittlung der Frequenz und Phase des Sendetakts aus dem binären Datenstrom.

In einem üblichen Empfänger dient das Taktsignal der Dekodierung der gesendeten Bitfolge durch Abtastung der empfangenen Signalpulse genau in der Mitte, zur Maximierung des Signal-Stör-Verhältnisses. Andererseits ist man zur Beurteilung der Signalqualität hauptsächlich an der zeitlichen Abweichung zwischen den Datenflanken und den zugehörigen Taktflanken interessiert. Zur Analyse der Zeitdifferenz, auch als Jitter bezeichnet, werden Augendiagramme und statistische Werkzeuge eingesetzt.

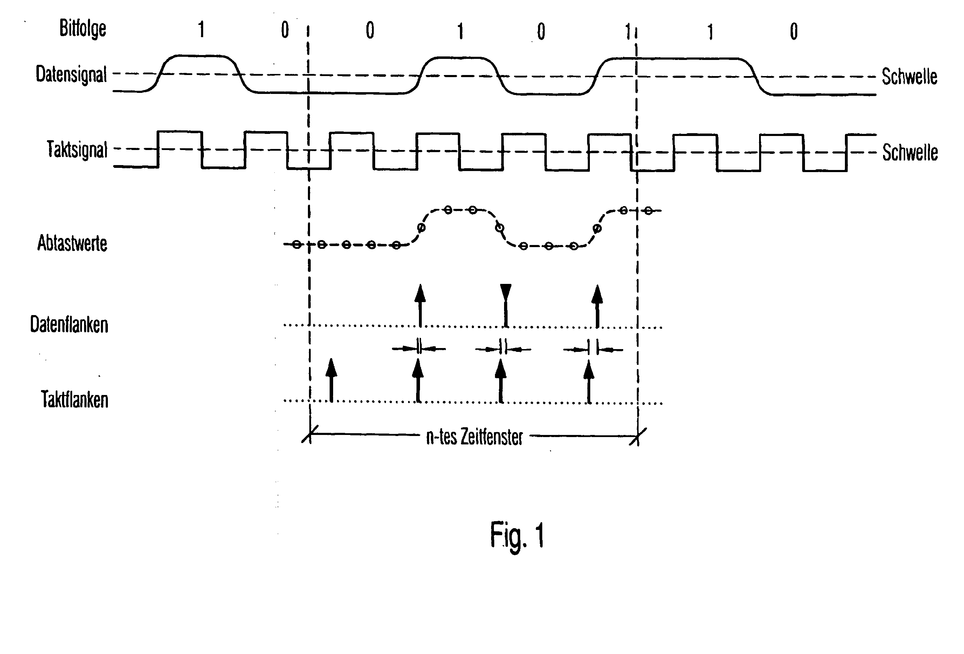

Figur 1 zeigt hierzu ein Signalbeispiel. Die Bitfolge "10010110" wird mit einem binären Datensignal übertragen. Das periodische Taktsignal, welches explizit bereit gestellt oder aus einem Datenstrom zurückgewonnen wird, dient der Dekodierung und zeitlichen Eingrenzung jedes versendeten Bits. Die Datenflanken entsprechen dem Zeitpunkt, bei welchem der Datenstrom mit beliebiger Steigung eine vorgegebene Schwelle überschreitet. Aus dem Taktsignal wird jede Periode eine Taktflanke gewonnen. In Figur 1 ist exemplarisch eine steigende Flanke eines Taktsignals gezeigt, welche den Bitbeginnzeitpunkt vorgibt.

Daten- und Taktflanken weichen aufgrund von Rauschen und Intersymbolinterferenz im Datensignal zeitlich voneinander ab. Die zeitliche Differenz zwischen den Datenflanken und den zugehörigen Taktflanken wird auch als Jitter bezeichnet. Eine sogenannte Jitteranalyse dient der Beurteilung der Signalqualität, typischerweise anhand so genannter Augendiagramme und anderer analytischer Werkzeuge.

Für die Durchführung einer Jitteranalyse ist eine höchstauflösende Ermittlung der Daten- und Taktflanken erforderlich. Im Stand der Technik werden hierzu Abtastwerte zunächst in einem Zwischenspeicher gesammelt und dann mittels einer geeigneten Software analysiert. Die höchstauflösende Ermittlung der Flanken durch Interpolation der im Speicher abgelegten Abtastwerten, was eine Vorstufe der meisten Jitteranalyseaufgaben darstellt, ist zeit- und rechenintensiv und bestimmt daher weitgehend, mit welchem Tempo neue Abtastwerteabschnitte aufgezeichnet und verarbeitet werden können.

Das US-Patent US 5,469,466 A offenbart ein Verfahren, welches unter anderem der Aufzeichnung von Jitter-Daten dient. Hierzu werden Datenflanken aus einem Datensignal bestimmt. Diese Bestimmung kann in Echtzeit erfolgen. Weiterhin werden ausgehend von den Datenflanken Taktflanken bestimmt. Auch diese Bestimmung kann in Echtzeit erfolgen. Zumindest die ermittelten Datenflanken werden dabei gespeichert. Nachteilig bei dem Verfahren nach der US 5.469.466 A ist, dass die Speicherung in einer ungeordneten Art und Weise erfolgt. Dies verursacht eine geringe Geschwindigkeit der Weiterverarbeitung. Weiterhin nachteilhaft ist, dass zur Weiterverarbeitung der von dem Verfahren erzeugten Daten aufwändige Synchronisierungsmaßnahmen notwendig sind.

Aufgabe der vorliegenden Erfindung ist daher, ein Verfahren und eine Vorrichtung zur platz- und zeitsparenden Aufzeichnung des Signalverlaufs sowie der zugehörigen Daten- und Taktflanken bereitzustellen.

ALLGEMEINE BESCHREIBUNG DER ERFINDUNG

Diese Aufgabe wird gelöst durch ein Verfahren und eine Vorrichtung gemäß den unabhängigen Patentansprüchen. Vorteilhafte Ausführungsformen sind in den Unteransprüchen definiert.

Das erfindungsgemäße Verfahren kann drei verschiedene Informationen verarbeiten: das abgetastete Signal, die Datenflanken und die Taktflanken. Die Taktflanken können rechnerisch aus einem zeitkontinuierlichen Taktsignal oder rechnerisch aus den Datenflanken bestimmt worden sein. Die zeitliche Auflösung der Daten- bzw. der Taktflanken ist höher als die Periode zur Abtastung des zeitkontinuierlichen Datenstroms.

Die zeitliche Lage dieser drei Größen (auf einer gemeinsamen Zeitachse) kann unterschiedlich repräsentiert werden. Bei bekannter und fester Abtastfrequenz kann man jeden Abtastwert des Signalverlaufs anhand dessen Abtastwertindex eindeutig auf der Zeitachse positionieren. Die Daten- und Taktflanken, welche in unregelmäßigen Abständen vorkommen können, können hingegen in der von Form Zeitstempeln kodiert werden. Jeder Zeitstempel drückt die Lage der zugehörigen Flanken auf der Zeitachse eindeutig und hochauflösend aus. Beispielsweise kennzeichnet ein Zeitstempel mit dem Wert "+4,35" eine steigende Taktflanke mit einem Versatz von 0,35 Abtastperioden zum 4 Abtastwert, wobei angenommen wird, dass die Abtastwertindices mit natürlichen Zahlen beschrieben werden.

Grundsätzlich lassen sich Abtastwerte und Flanken beliebig speichern. Da sie alle die gleiche Zeitreferenz teilen, ist die Rekonstruktion ihrer Lage auf der Zeitachse ohne Synchronisationsverlust möglich. Jedoch ist die zusammenhängende Speicherung wegen einer effizienten Nachverarbeitung und Visualisierung vorteilhaft.

Hierfür kann die Zeitachse in aufeinander folgende, sich nicht überlappende Zeitfenster aufgeteilt werden. Pro Zeitfenster können die Signalabtastwerte und die Zeitstempel zu den darin auftretenden Daten- und Taktflanken zusammenhängend gespeichert werden. Durch die Speicherung in einem gemeinsamen Block eines digitalen Datenspeichers können die Daten- und Taktflanken für eine Nachverarbeitung und/oder Visualisierung effizient bereit gestellt werden.

Verfahren und Vorrichtung arbeiten in Echtzeit, d.h. ohne die Abtastwerte zwischenzuspeichem und die Weiterverarbeitung der Daten- und Taktflanken, insbesondere ihre Anzeige bzw. Visualisierung zu verzögern. Die Taktrückgewinnung wird hierzu durch einen Hardwarebaustein ausgeführt.

KURZE FIGURENBESCHREIBUNG

Fig. 1 ist eine Darstellung eines Signalbeispiels.

Fig. 2 zeigt ein Flussdiagramm eines Verfahrens zur Aufzeichnung von Jitterdaten gemäß einer ersten Ausführungsform der Erfindung.

Fig. 3 zeigt ein Flussdiagramm eines Verfahrens zur Aufzeichnung von Jitterdaten gemäß einer zweiten Ausführungsform der Erfindung.

Fig. 4 zeigt eine vereinfachte Struktur einer PLL zur Rückgewinnung von Taktflanken aus einem Datensignal gemäß einer Ausführungsform der Erfindung.

Fig. 5 zeigt eine Struktur des Kerns einer PLL zur Rückgewinnung von Taktflanken gemäß einer weiteren Ausführungsform der Erfindung.

Fig. 6 zeigt den Aufbau eines Systems gemäß einer Ausführungsform der Erfindung.

Fig. 7 zeigt ein Blockschaltbild eines Systems gemäß einer weiteren Ausführungsform der Erfindung.

Fig. 8 zeigt vereinfacht das zusammenhängende Speichern der drei Signalarten gemäß einer Ausführungsform der Erfindung.

Fig. 9 zeigt einen Zeitstempel in allgemeiner Form.

DARSTELLUNG EINES AUSFÜHRUNGSBEISPIELS

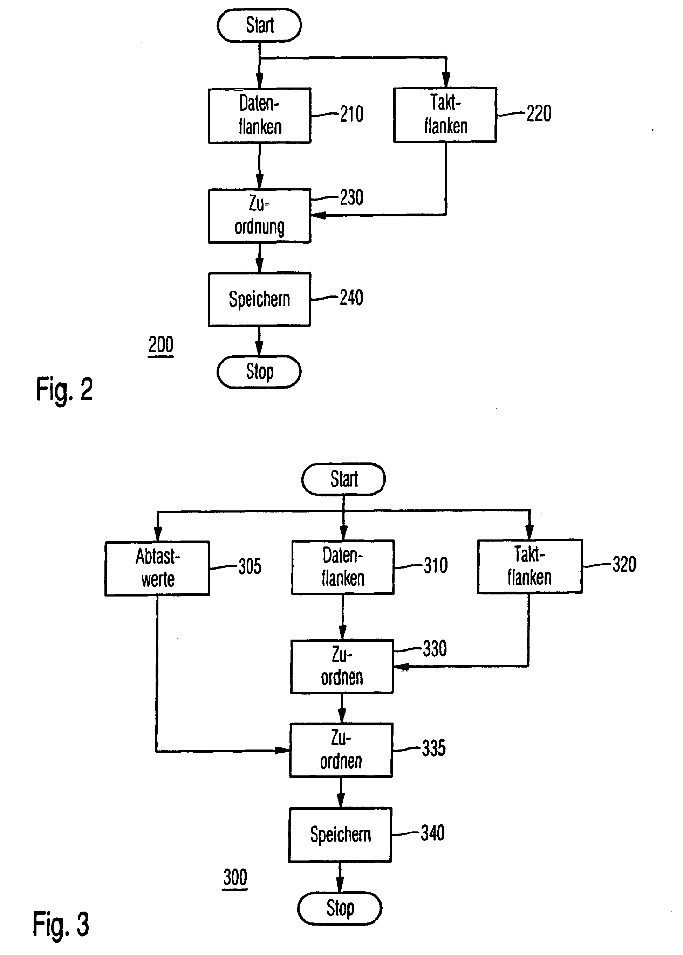

**Figur 2** zeigt ein Verfahren zur Aufzeichnung von Jitterdaten gemäß einer ersten Ausführungsform der Erfindung.

In Schritt **210** wird eine Sequenz von Datenflanken aus einem Datensignal bestimmt. Das Eingangssignal kann ein zeitkontinuierliches, binäres Datensignal sein. Exemplarisches Einsatzgebiet solcher Signale ist die serielle Übertragung von Bitfolgen (RS-232, USB, FibreChannel, SATA ...).

Die Sequenz von Datenflanken kann durch Zeitstempel repräsentiert werden, d.h. durch Zeitpunkte, an denen das Eingangs- oder Datensignal eine vorgegebene Schwelle über- und unterschreitet. Die Lage dieser Zeitpunkte kann mit höherer Auflösung als die Abtastperiode bestimmt werden.

In Schritt **220** wird eine Sequenz von Taktflanken aus dem Datensignal bestimmt. Die Taktflanken können zur Aufzeichnung bereitgestellt werden.

In Schritt **230** wird mindestens einer Taktflanke aus der Sequenz von Taktflanken zu mindestens einer Datenflanke aus der Sequenz von Datenflanken zugeordnet. Die Zuordnung von Daten- und Taktflanken kann anhand des Zeitstempels erfolgen. Nach Bedarf können die Daten- und Taktflanken gegeneinander verzögert werden. Die Verzögerung kann mittels eines FIFO-Blocks realisiert werden.

In Schritt **240** werden die mindestens eine Datenflanke und die mindestens eine Taktflanke in einem gemeinsamen Block eines digitalen Datenspeichers gespeichert. Der gemeinsame Block des digitalen Datenspeichers kann eine logische Speicherseite eines seitenorientierten virtuellen Speichers sein.

**Figur 3** zeigt ein Flussdiagramm eines Verfahrens zur Aufzeichnung von Jitterdaten gemäß einer zweiten Ausführungsform der Erfindung. Die Nummerierung der Verfahrensschritte erfolgt analog zu Figur 2.

In Schritt **305** wird, zusätzlich zu den im Zusammenhang mit Figur 2 geschilderten Schritten, eine Sequenz von Abtastwerten des Datensignals bestimmt. Das Datensignal kann hierzu durch einen Signalaufnehmer aufgenommen und dann durch einen A/D-Wandler abgetastet und quantisiert werden.

In Schritt **335** wird, mindestens ein Abtastwert aus der Sequenz von Abtastwerten zu der Datenflanke aus der Sequenz von Datenflanken oder zu der Taktflanke aus der Sequenz von Taktflanken zugeordnet. Die Daten- und Taktflanke können bereits in einem sogenannten 'Jitterwort' in geeigneter Weise zusammengefasst sein.

Die Zuordnung kann über eine gemeinsame Zeitreferenz erfolgen. Die Lage der Abtastwerte auf der Zeitachse kann durch deren Index mal die Abtastperiodendauer bestimmt werden. Die Daten- und Taktflanken können ihre zeitliche Lage in Form von Zeitstempeln explizit angeben. Nach Bedarf können die Abtastwerte bezüglich der Daten- und Taktflanken verzögert werden. Die Verzögerung, welche üblicherweise einem Vielfachen der Abtastperiode entspricht, kann mittels eines FIFO-Blocks realisiert werden. Ingesamt kümmern sich die Blöcke **330** und **335** um die Zuordnung der Abtastwerte, Datenflanken und Taktflanken, wobei nach Bedarf alle drei Sequenzen gegeneinander verzögert werden können.

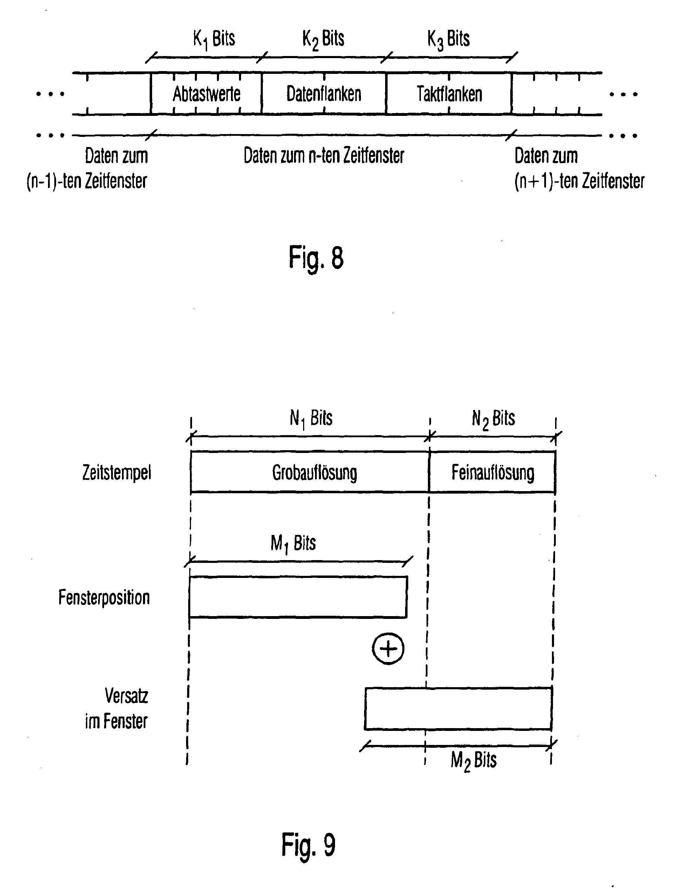

Wenn mehrere Abtastwerte, etwa aus einem definierten Zeitfenster gespeichert werden sollen, kann die Zuordnung von Abtastwerten, Datenflanken und Taktflanken ein definiertes Interleaving von Abtastwerten, Datenflanken und Taktflanken umfassen. Ein Beispiel hierfür wäre ein wiederholtes Speichern der Abtastwerte eines Signalabschnitts- oder Fensters sowie der dort auftretenden Daten- und Taktflanken nacheinander, wie in **Fig. 8** vereinfacht dargestellt.

Um einen konstanten Durchsatz des Jitterdatenstroms zu erreichen, können beim Interleaving leere Jitterfüllworte eingefügt werden.

In Schritt **340** wird der mindestens eine Abtastwert mit der Datenflanke und der Taktflanke in dem gemeinsamen Block des digitalen Datenspeichers aufgezeichnet.

Vor der Aufzeichnung kann beispielsweise das Abtastsignal noch einer Dezimation, Interpolation oder Filterung unterworfen werden. Schließlich kann die zeitliche Differenz zwischen Daten- und Taktflanken laufend berechnet werden, einschließlich statistischer Auswertungen.

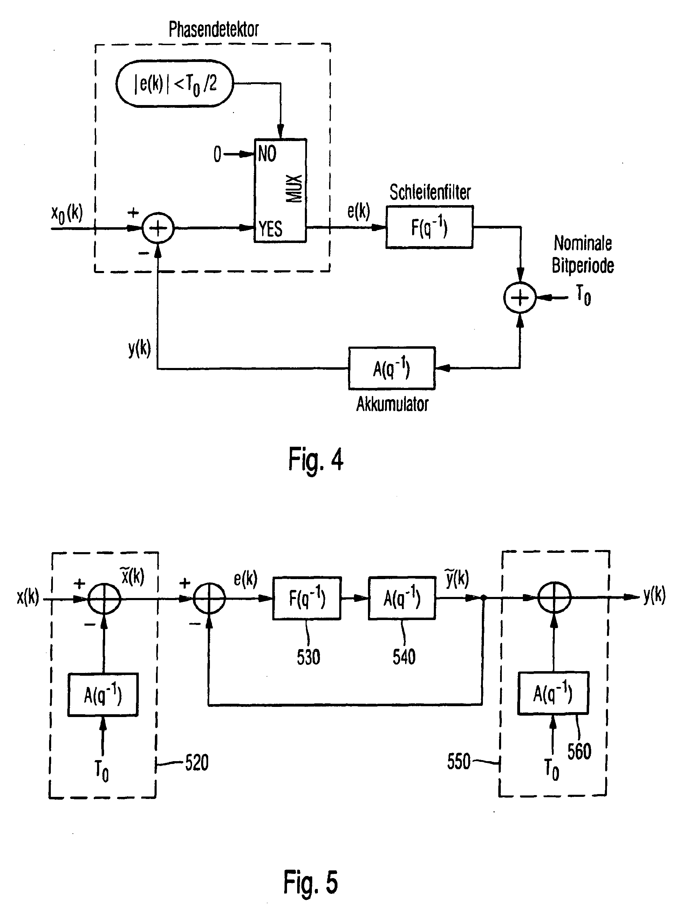

**Figur 4** zeigt die vereinfachte Struktur einer PLL zur Bestimmung einer Sequenz von Taktflanken aus einem Datensignal gemäß einer Ausführungsform der Erfindung. Das Eingangssignal $x_0(k)$ ist eine Liste mit der zeitlichen Position der Nulldurchgänge im Datenstrom, im Folgenden auch Datenflanken genannt. Mit $y(k)$ werden die berechneten Taktflanken bezeichnet. Die PLL generiert nur eine Taktflanke pro Bitperiode. Stellt man sich das zugrunde liegende, zeitkontinuierliche Taktsignal als eine Sinusschwingung vor, dann bezeichnet $y(k)$ die Zeitpunkte mit Phase gleich 0.

Die $x_0(k)$ sind chronologisch geordnet und werden sequenziell verarbeitet. Zunächst wird im Phasendetektor die Zeitdifferenz $e(k)$ zwischen Daten- und Taktflanken gebildet Der Term $e(k)$ wird mit dem Schleifenfilter (Engl: loop filter) $F(q^{-1})$ gefiltert. $F(q^{-1})$ beschreibt eine Differenzengleichung als Funktion des Verzögerungsoperators $q^{-1}$, für den exemplarisch gilt: $2 \cdot q^{-1} \cdot e(k) = 2 \cdot e(k-1)$. Das resultierende $d(k)$ zusammen mit der Konstante $T_0$, welche die nominale Bitperiode des Datenstroms angibt, liefert eine Schätzung der momentanen Bitperiode des Datenstroms. Der Akkumulator $A(q^{-1})$ ermittelt die Lage der nächsten Taktflanke, indem die momentane Bitperiodenschätzung zur letzten Taktflanke hinzuaddiert wird. Algorithmisch lässt sich die grundlegende Funktionsweise wie folgt beschreiben:

| | |
|---|---|
| Phasen- bzw. Timing-Fehler: | $e(k) = x_0(k) - y(k)$ |
| Gefilterter Fehler: | $d(k) = F(q^{-1}) \cdot e(k)$ |
| Momentane Bitperiodenschätzung: | $T_b(k) = T_0 + d(k)$ |
| Nächste Taktflanke: | $y(k+1) = q \cdot A(q^{-1}) \cdot T_b(k)$ |

Durch gezielte Wahl der Koeffizienten von $F(q^{-1})$ und $A(q^{-1})$ kann die obige Software-PLL, solange sie offline arbeitet, die theoretische PLL-Übertragungsfunktion sehr gut approximieren.

Da kein Signaldurchgang stattfindet, wenn der Sender zwei oder mehr gleiche Bits nacheinander überträgt, kann die Datenflankenanzahl in der Praxis überdies kleiner als die Anzahl übertragener Bits sein. Daher ist in der PLL gemäß Figur 1 ferner ein Multiplexer zur Behandlung von Flankenlücken vorgesehen. Ist beispielsweise der Zeitdifferenzbetrag größer als eine halbe Bitperiode $T_0$, kann eine Flankenlücke angenommen und $e(k) = 0$ gesetzt werden, andernfalls kann der Phasendetektor die Zeitdifferenz $e(k)$ unverändert weiterleiten.

**Figur 5** zeigt die Struktur des Kerns einer PLL gemäß einer weiteren Ausführungsform der Erfindung. Der Beitrag der nominalen Bitperiode $T_0$, welche die PLL bei unterdrücktem Schleifenfilterausgang mit der nominalen Bitperiode laufen lässt und in einer zeitkontinuierlichen PLL der Nominalfrequenz des VCOs (Englisch: Voltage Controlled Oscillator) entspricht, wird in Figur 5 aus der Schleife beseitigt und durch eine Vor- und eine Nachverarbeitungsstufe ersetzt.

Das Schleifenfilter $F(q^{-1})$ und der Akkumulator $A(q^{-1})$ definieren herkömmliche lineare Differenzengleichungen als Funktion des Verzögerungsoperators $q^{-1}$. Beispielsweise beschreibt

$$a(k) = G(q^{-1})b(k) \quad \text{mit} \quad G(q^{-1}) = \frac{1 + g_2 \cdot q^{-1}}{1 - g_1 \cdot q^{-1}}$$

die Differenzengleichung

$$a(k) - g_1 \cdot a(k-1) = b(k) + g_2 \cdot b(k-1) \,.$$

Gemäß Figur 1 gilt

$$y(k) = A(q^{-1}) \cdot \left( F(q^{-1}) \cdot \left( x(k) - y(k) \right) + T_0 \right). \qquad (1)$$

Definiert man

$$\tilde{x}(k) = x(k) - A(q^{-1}) \cdot T_0 \,, \qquad \tilde{y}(k) = y(k) - A(q^{-1}) \cdot T_0 \,. (2)$$

zeigt sich, dass der Term $t(k) = A(q^{-1}) \cdot T_0$ das Akkumulieren bzw. Integrieren eines konstanten Signals mit wachsendem Flankenindex k **beschreibt** und funktionell eine Gerade der Steigung $T_0$ definiert.

Aus Gleichungen (1) und (2) ergibt sich

$$y(k) = \begin{array}{l} A(q^{-1}) \cdot \left( F(q^{-1}) \cdot \left( x(k) - y(k) \right) \right) + A(q^{-1}) \cdot T_0 \\ A(q^{-1}) \cdot \left( F(q^{-1}) \cdot \left( x(k) - y(k) + A(q^{-1}) \cdot T_0 - A(q^{-1}) \cdot T_0 \right) \right) + A(q^{-1}) \cdot T_0 \,. \\ A(q^{-1}) \cdot \left( F(q^{-1}) \cdot \left( \tilde{x}(k) - \tilde{y}(k) \right) \right) + A(q^{-1}) \cdot T_0 \end{array} \qquad (3)$$

Daraus folgt schließlich

$$\tilde{y}(k) = A(q^{-1}) \cdot F(q^{-1}) \cdot \left( \tilde{x}(k) - \tilde{y}(k) \right) \qquad (4)$$

Gleichung (4) entspricht der Regelschleife des PLL-Kerns in Figur 5, wobei Gleichung (2) die Vorverarbeitungsstufe ('Trendabzug') und die Nachverarbeitungsstufe ('Trend-injektion') beschreibt.

Ein zusätzlicher Aufwand ergibt sich aufgrund der Vor- und Nachverarbeitungsstufen. Der Term $t(k) = A(q^{-1}) \cdot T_0$ aus Gleichung (2) beschreibt eine Gerade der konstanten Steigung $T_0$ über den Index k. Der Vorverarbeitungsblock zieht diesen linearen Trend von den ankommenden Datenflanken $x(k)$ ab und der Nachverarbeitungsblock addiert ihn wieder zum PLL-Ausgang.

Grundsätzlich stellen die Datenflankenpositionen des analysierten Datenstroms eine Gerade der Steigung $T_b$ über den Index k dar. Nach Abzug des linearen Trends bleibt ein Resttrend der Steigung $(T_b - T_0)$ übrig. Folglich wachsen die Terme $|\tilde{x}(k)|$ und $|\tilde{y}(k)|$ mit der Zeit uneingeschränkt, wenn die Datenstrombitperiode $T_b$ vom nominalen Wert $T_0$ abweicht. Damit $|\tilde{x}(k)|$ und $|\tilde{y}(k)|$ begrenzt bleiben, müssen beide Größen gelegentlich um einen bestimmten Offset zurückgesetzt werden. Dies kann durch gleichzeitige Erhöhung der Hilfsblöcke und Rücksetzung des Zustands der Hauptregelschleife, im Folgenden auch PLL-Kern genannt, um den gleichen Offsetwert erfolgen. Damit bleibt die Differenz $e(k) = \tilde{x}(k) - \tilde{y}(k)$ erhalten.

Konsequenz der in Figur 5 gezeigten Struktur ist, dass sich die Übertragungsfunktion der Regelschleife als lineares, rationales Filter bzw. lineare Differenzengleichung

$$H(q^{-1}) = \frac{F(q^{-1}) \cdot A(q^{-1})}{1 + F(q^{-1}) \cdot A(q^{-1})} = \frac{\displaystyle\sum_{n=0}^{N} b_n \cdot q^{-n}}{\displaystyle\sum_{m=0}^{M} a_m \cdot q^{-m}} \qquad (5)$$

ausdrücken lässt. Durch die Umwandlung in eine Differenzengleichung geht die ursprüngliche Struktur der Software-PLL aus Figur 1 größtenteils verloren, beispielsweise werden die Größen $e(k)$ und $d(k)$ nicht mehr explizit berechnet. Der Vorteil ist jedoch, dass Gleichung (5) mit aus der Literatur bekannten Verfahren in Pipeline-Form und serieller oder paralleler Ausführung realisierbar ist.

Das heißt insbesondere kann die Implementierung aller Funktionsblöcke zur Steigerung der Arbeitsgeschwindigkeit parallel erfolgen. Darunter versteht man, dass mehrere aufeinander folgende Elemente der Datenflankenfolge $x_0(k)$ im gleichen Arbeitsschritt verarbeitet werden. Die resultierende Taktflankenfolge y(k) ist theoretisch identisch zur sequenziellen Verarbeitung von $x_0(k)$ mit einer herkömmlichen Software-PLL nach dem Stand der Technik.

Der parallele Aufbau des Trendabzugsblocks und des Trendinjektionsblocks ist unkompliziert, denn der nominale Takt läuft mit der im Voraus bekannten nominalen Bitperiode $T_0$ weiter. Zur parallelen Realisierung des linearen Filters bzw. der linearen Differenzengleichung aus Gleichung (5) können aus der Literatur bekannte Verfahren zur rekursiven Blockfilterung (Englisch: pipelined block filtering) verwendet werden.

Grundlegende Ansätze hierzu werden in den beiden Artikeln von K. Parhi und D. Messerschmitt ("Pipeline Interleaving and Parallelism in Recursive Digital Filters - Part I: Pipelining Using Scattered Look-Ahead and Decomposition" und "Pipeline Interleaving and Parallelism in Recursive Digital Filters - Part II: Pipelined Incremental Block Filtering", IEEE Transactions on Acoustics, Speech and Signal Processing, Vol. 37, No. 7, Juli 1989, Seiten 1099 bis 1117 bzw. Seiten 1118 bis 1134) beschrieben. An dieser Stelle beschränkt der langsamste grundlegende Verarbeitungsschritt die maximal analysierbare Datenstrombitrate, typischerweise der Systemtakt, und nicht die Gesamtverarbeitungszeit des Regelkreises wie in einer herkömmlichen Software-PLL.

Eine Stufe zur Zuordnung der Takt- und Datenflanken kann außerhalb des Regelkreises in einen vorgeschalteten Block (Edge Matching and Patching Unit oder EMPU) verlagert werden (nicht gezeigt). Aus einer rohen Datenflankenfolge $x_0(k)$, welche in der Regel mehrere Flankenlücken aufweist, liefert die EMPU eine interpolierte, lückenlose Datenflankenfolge x(k). Die EMPU kann mit dem Hauptregelkreis beispielsweise über die zurückgewonnenen Taktflanken y(k) gekoppelt sein.

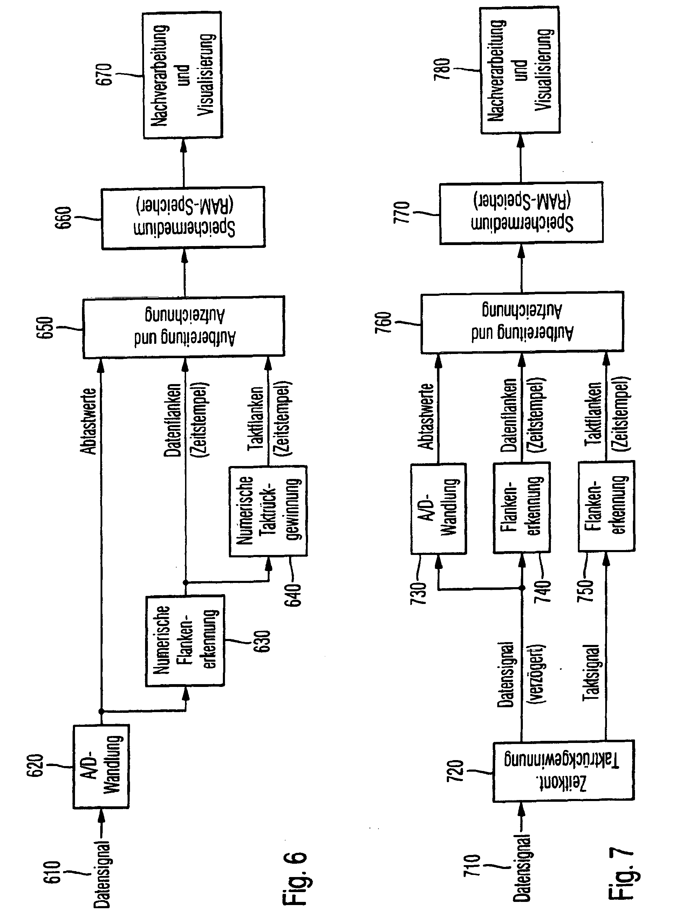

**Figur 6** zeigt den Aufbau eines Systems gemäß einer Ausführungsform der Erfindung. Ein zeitkontinuierliches, binäres Datensignal **610** wird zunächst mittels eines A/D-Wandlers **620** abgetastet. Ein Flankenerkennungsblock **630** interpoliert das Abtastsignal numerisch und ermittelt daraus die Position der Datenflanken. Die Zeitauflösung kann einem Bruchteil einer Abtastperiode entsprechen. Datenflanken können in Form von Zeitstempeln ausgedrückt werden.

Die Flanken des unterliegenden Taktsignals können mit einem numerischen Taktrückgewinnungsblock **640** direkt aus den Datenflanken bestimmt werden.

Abtastwerte, Datenflanken und Taktflanken können laufend, in Echtzeit bestimmt werden. Der Taktrückgewinnungsblock **640** kann dem Aufbereitungs- und Aufzeichnungsblock **650** die Datenflanken zusammen mit den zugehörigen Taktflanken in der Form von so genannten Jitterworten bereitstellen. Jitterworte sind Pakete von einander zugeordneten Daten- und Taktflanken.

Die Jitterworte im Aufbereitungs- und Aufzeichnungsblock **650** können mit den Abtastwerten von einem oder mehreren abgetasteten Kanälen verbunden und in einem Speichermedium **660** aufgezeichnet werden.

Da der Aufbereitungs- und Aufzeichnungsblock **650** einen regelmäßigen Jitterdatenstrom bei gleichzeitigem Aufzeichnen von Sampledaten benötigt, kann er, falls erforderlich, leere Jitterfüllworte einfüllen.

Nach der Akquisition des interessierenden Signalabschnitts kann das erfindungsgemäße System auf Offline-Modus umgeschaltet werden. Die Daten können nun aus dem Speicher **660** gelesen und zur Signalanalyse und -Darstellung in einem weiteren Block **670** weiter verarbeitet werden. Hiernach können neue Daten aufgezeichnet werden.

Insbesondere können alle drei Signalarten (Abtastwerte, Datenflanken und Taktflanken) in Echtzeit ermittelt und gespeichert werden. Vorrichtungen nach dem Stand der Technik zeichnen in Echtzeit nur die Abtastwerte auf und bestimmen daraus dann im Offline-Modus die Daten- und die Taktflanken, um sie anschließend für Analyse- und Darstellungszwecke weiter zu verarbeiten. Diese Offline-Ermittlung der Daten- und Taktflanken ist sehr zeitaufwendig. Die Rate, mit welcher neue Signalabschnitte aufgezeichnet werden können, sinkt hierdurch erheblich.

**Figur 7** zeigt ein Blockschaltbild eines Systems gemäß einer weiteren Ausführungsform der Erfindung.

Der Unterschied zu Figur 6 liegt in der Ermittlung der drei Signalarten. Ein zeitkontinuierliches Datensignal **710** wird jetzt zu einer Taktrückgewinnungsschaltung **720** geführt. Am Ausgang der Schaltung liegen das gleiche Datensignal wie am Eingang, in der Regel nur leicht verzögert, und das zurückgewonnene Taktsignal an.

Das zeitkontinuierliche Datensignal wird sowohl mittels eines A/D-Wandlers **730** abgetastet als auch zu einer Flankenerkennungsschaltung **740** zur Bestimmung der Datenflanken geführt. Eine weitere Flankenerkennungsschaltung **750** ermittelt die Taktflanken aus dem zeitkontinuierlichen Taktsignal.

Man beobachte, dass sich die Flankenerkennungsschaltung **750** als das Zusammenschalten der Blöcke AD-Wandlung **620** und Numerische Flankenerkennung **630** aus Figur 6 verstehen lässt.

Figur 7 verdeutlicht, dass andere Systemeinrichtungen die laufende, echtzeitfähige Bestimmung der drei interessierenden Signalarten erlauben.

In einer weiteren Ausführungsform der Erfindung (nicht dargestellt) kann das analysierte Protokoll den Takt als separates Signal mitliefern. Auf eine Taktrückgewinnungsschaltung kann dann verzichtet werden.

**Figur 8** zeigt vereinfacht das zusammenhängende Speichern der drei Signalarten gemäß einer Ausführungsform der Erfindung. Angenommen wird, dass die Speicheradresse von links nach rechts zunimmt. Pro Zeitfenster wird eine Datenstruktur angelegt, wobei die Datenstruktur abhängig von den Aufzeichnungseinstellungen variieren kann. Abtastwerte, Datenflanken und Taktflanken werden interleaved bzw. abwechselnd gespeichert.

- Der Abtastwertebereich ist K1 Bits breit und kann bis zu fünf Abtastwerte speichern.
- Die Datenflanken belegen K2 Bits. Gemäß der Zeichnung passen höchstens zwei Datenflanken im vorgesehen Speicherbereich. Treten mehr als zwei Datenflanken innerhalb eines Fensters auf, dann werden die überflüssigen Flanken ausgestoßen und gehen verloren. Treten weniger als zwei Flanken oder sogar keine Flanke auf, dann wird der Platzhalter zum Gewährleisten einer regelmäßigen Speicherstruktur oder eines konstanten Datendurchsatzes beibehalten.
- Die Taktflanken belegen K3 Bits, wobei oft K3 = K2. Für die Taktflanken gelten die gleichen Regeln wie für die Datenflanken.

Um die Speichermenge K2 bzw. K3 klein zu halten, ist die Synchronisierung von Abtastwerten, Datenflanken und Taktflanken zweckmäßig. Insbesondere das zusammenhängende Speichern beider Flankenarten ist vorteilhaft.

Zur Erläuterung zeigt **Figur 9** einen Zeitstempel in allgemeiner Form.

Die zeitliche Position einer Flanke bezüglich der Systemzeit (beispielsweise den Einschaltzeitpunkt des Systems) wird mit $(N1+N2)$ Bits gegeben, wobei N1 die Lage als Vielfaches einer Abtastperiode ausdrücken und N2 Bits die Feinauflösung (Bruchteil einer Abtastperiode) angeben. Der Zeitstempel lässt sich also als Summe von zwei Anteilen darstellen, nämlich die Fensterposition und einen Offset/Versatz zum Fenster.

Mehrere Ansätze sind zum Speichern von L1 Datenflanken und L2 Taktflanken denkbar (wo üblicherweise L1=L2). Die Ansätze sind nach absteigendem Speicherbedarf sortiert.

1. Ein ganzer Zeitstempel wird pro Flanke verwendet. Dies erfordert $S1 = (N1+N2)*(L1+L2)$ Bits.

2. Setzt man voraus, dass alle Flanken im gleichen Zeitfenster vorkommen, dann kann man zunächst die gemeinsame Fensterposition einmal speichern (M 1 Bits) und dann den Offset der Flanken zum Fensterbeginn. Dies erfordert $S2 = M1 + M2*(L1+L2)$ Bits.

3. Das Speichern der Fensterposition (M1 Bits) ist überflüssig, wenn ein Zähler im Hintergrund den "Fensterindex" mitzählt. Nach geeigneter Initialisierung wird der Zähler beim Lesen eines neuen Datenblocks um die Fensterlänge erhöht. Zu diesem Wert werden die Flankenoffsets addiert, um die Daten- und Taktflanken zu erhalten. Nach erneutem Addieren der Fensterlänge zum Zähler wird der nächste Datenblock verarbeitet.

Vorzugsweise kann eine Variante von Ansatz 2 verwendet werden, wenn Abtastwerte und Flanken nicht vollkommen synchronisiert sind. So werden in einem Datenblock der Länge $(K1+K2+K3)$ Bits aus Figur 8 die Abtastwerte des n-ten Zeitfensters und die Flanken des $(n+P)$-ten Fensters zusammen gespeichert, wobei P>0 und abhängig von den Einstellungen leicht variiert. Zur Kodierung der Flanken wird Ansatz 2 genutzt, also gemeinsame Fensterposition plus Flankenoffset. Die zeitliche Zuordnung der Abtastwerte kann mit Hilfe eines externen Zählers verfolgt werden.

Das zusammenhängende Speichern der drei Signalarten wurde anhand Figur 8 erläutert. Jeder Speicherstruktur aus $(K1+K2+K3)$ Bits erfasst die Abtastwerte, Datenflanken und Taktflanken aus einem Zeitfenster. Die maximale, ununterbrochene Beobachtungszeit hängt davon ab, wieviele aufeinander folgende Zeitfenster aufgezeichnet werden können. Dies steht in direktem Verhältnis zur maximalen Anzahl von Speicherstrukturen, die in den Systemspeicher passen.

Möchte man nur die Daten- und Taktflanken aufzeichnen, dann können Zeitfenster, wo keine Flanken auftreten, ignoriert oder übersprungen werden. Die maximale, ununterbrochene Beobachtungszeit wird nun maßgebend vor der Häufigkeit der Flanken bestimmt. Insbesondere bei der Analyse von Datenströmen mit niedrigen Bitraten (d.h. mit großen Bitperioden) kann man hohe Beobachtungszeiten bei verhältnismäßig kleinem Speicherverbrauch erreichen.

Ferner ist das Aufzeichnen der Daten- oder der Taktflanken für einige Analysefunktionen überflüssig. Beispielsweise sind die Datenflanken zur Messung des so genannten Periodenjitters (engl: periodjitter) ausreichend. Unter diesen Umständen kann das Speichern der überflüssigen Flankenart (hier die Taktflanken) zur besseren Ausnützung des Speicherplatzes und entsprechender Erhöhung der maximalen Beobachtungszeit unterdrückt werden.

**Patentansprüche**

1.  Verfahren zur Aufzeichnung von Jitterdaten,
    mit den Schritten:

    - Bestimmen (210) einer Sequenz von Datenflanken aus einem Datensignal in Echtzeit;
    - Bestimmen (220) einer Sequenz von Taktflanken aus dem Datensignal in Echtzeit;

    **gekennzeichnet durch die folgenden Schritte:**

- Zuordnen (230) mindestens einer Taktflanke aus der Sequenz von Taktflanken zu mindestens einer Datenflanke aus der Sequenz von Datenflanken, wobei die Sequenz von Datenflanken verzögert wird, um eine näherungsweise Synchronisierung mit der Sequenz von Taktflanken zu erreichen;
- Aufzeichnen (240) der mindestens einen Datenflanke und der mindestens einen zugeordneten Taktflanke in einem gemeinsamen Block eines digitalen Datenspeichers in Echtzeit.

2.  Verfahren nach Patentanspruch 1, ferner umfassend die Schritte:

- Bestimmen (305) einer Sequenz von Abtastwerten des Datensignals in Echtzeit;
- Zuordnen (335) mindestens eines Abtastwertes zu der Datenflanke aus der Sequenz von Datenflanken oder zu der Taktflanke aus der Sequenz von Taktflanken; und
- Aufzeichnen (340) des mindestens einen Abtastwertes mit der Datenflanke und der Taktflanke in dem gemeinsamen Block des digitalen Datenspeichers in Echtzeit.

3.  Verfahren nach Patentanspruch 1, wobei die Sequenz von Datenflanken und die Sequenz von Taktflanken jeweils durch eine Sequenz von Zeitstempeln repräsentiert sind.

4.  Verfahren nach Patentanspruch 3, wobei die Zuordnung anhand des jeweiligen Zeitstempels erfolgt.

5.  Verfahren nach Patentanspruch 2, wobei die Sequenz von Abtastwerten verzögert wird, um eine Synchronisierung mit der Sequenz von Taktflanken zu erreichen.

6.  Verfahren nach Patentanspruch 1, wobei der Schritt des Bestimmens (220) einer Sequenz von Taktflanken aus dem Datensignal in Echtzeit ferner die Schritte umfasst:

- Bereinigen des Datensignals um einen Trend;
- Filtern des bereinigten Datensignals, um eine bereinigte Sequenz von Taktflanken zu erhalten.

7.  Vorrichtung zur Aufzeichnung von Jitterdaten, umfassend:

- einen Signalaufnehmer (620) zum Aufnehmen eines binären Datensignals (610);
- einen Flankenerkennungsblock (630) zum Bestimmen einer Sequenz von Datenflanken aus dem Datensignal in Echtzeit;
- einen Taktrückgewinnungsblock (640) zum Bestimmen einer Sequenz von Taktflanken aus dem Datensignal in Echtzeit;

**gekennzeichnet durch**

- einen Zuordnungsblock (650) zum Zuordnen mindestens einer Taktflanke aus der Sequenz von Taktflanken zu einer Datenflanke aus der Sequenz von Datenflanken, wobei die Sequenz von Datenflanken durch einen FIFO-Block verzögert wird, um eine näherungsweise Synchronisierung mit der Sequenz von Taktflanken zu erreichen;
- einen Aufzeichnungsblock (650) zum Aufzeichnen der Datenflanke und der mindesten einen zugeordneten Taktflanke in einem gemeinsamen Block eines digitalen Datenspeichers (660) in Echtzeit.

8.  Vorrichtung nach Patentanspruch 7, ferner:

- Mittel zum Bestimmen einer Sequenz von Abtastwerten des Datensignals in Echtzeit;
- Mittel zum Zuordnen mindestens eines Abtastwertes zu der Datenflanke aus der Sequenz von Datenflanken oder zu der Taktflanke aus der Sequenz von Taktflanken; und
- Mittel zum Aufzeichnen des mindestens einen Abtastwertes mit der Datenflanke und der Taktflanke in dem gemeinsamen Block des digitalen Datenspeichers in Echtzeit.

9.  Vorrichtung nach Patentanspruch 8, wobei die Sequenz von Datenflanken und die Sequenz von Taktflanken jeweils durch eine Sequenz von Zeitstempeln repräsentiert sind.

10. Vorrichtung nach Patentanspruch 9, wobei die Zuordnung anhand des jeweiligen Zeitstempels erfolgt.

**11.** Vorrichtung nach Patentanspruch 7, wobei der gemeinsame Block des digitalen Datenspeichers eine logische Speicherseite eines seitenorientierten virtuellen Speichers ist.

**12.** Vorrichtung nach Patentanspruch 7, wobei der Taktrückgewinnungsblock (640) zum Bestimmen einer Sequenz von Taktflanken aus dem Datensignal in Echtzeit ferner umfasst:

- Mittel zum Bereinigen des Datensignals um einen Trend;
- Mittel zum Filtern des bereinigten Datensignals, um eine bereinigte Sequenz von Taktflanken zu erhalten.

**Claims**

**1.** Method for recording jitter data, having the steps of:

- determining (210) a sequence of data flanks from a data signal in real time;
- determining (220) a sequence of clock flanks from the data signal in real time;

**characterized by** the following steps:

- assigning (230) at least one clock flank for the sequence of clock flanks to at least one data flank for the sequence of data flanks, the sequence of data flanks being delayed in order to achieve an approximate synchronization with the sequence of clock flanks;
- recording (240) the at least one data flank and the at least one assigned clock flank in a common block of a digital data memory in real time.

**2.** Method according to Patent Claim 1, further comprising the steps of:

- determining (305) a sequence of sample values of the data signal in real time;
- assigning (335) at least one sample value to the data flank from the sequence of data flanks or to the clock flank from the sequence of clock flanks; and
- recording (340) the at least one sample value with the data flank and the clock flank in the common block of the digital data memory in real time.

**3.** Method according to Patent Claim 1, in which the sequence of data flanks and the sequence of clock flanks are respectively represented by a sequence of time stamps.

**4.** Method according to Patent Claim 3, in which the assignment is performed with the aid of the respective time stamp.

**5.** Method according to Patent Claim 2, in which the sequence of sample values is delayed in order to achieve a synchronization with the sequence of clock flanks.

**6.** Method according to Patent Claim 1, in which the step of determining (220) a sequence of clock flanks from the data signal in real time further comprises the steps of:

- cleaning the data signal around a trend;
- filtering the cleaned data signal in order to obtain a cleaned sequence of clock flanks.

**7.** Device for recording jitter data, comprising:

- a signal sensor (620) for picking up a binary data signal (610);
- an flank recognition block (630) for determining a sequence of data flanks from the data signal in real time;
- a clock recovery block (640) for determining a sequence of clock flanks from the data signal in real time;

**characterized by**

- an assigning block (650) for assigning at least one clock flank from the sequence of clock flanks to a data flank from the sequence of data flanks, the sequence of data flanks being delayed by a FIFO block in order to achieve an approximate synchronization with the sequence of clock flanks;

- a recording block (650) for recording the data flank and the at least one assigned clock flank in a common block of a digital data memory (660) in real time.

8. Device according to Patent Claim 7, further comprising:

- means for determining a sequence of sample values of the data signal in real time;
- means for assigning at least one sample value to the data flank from the sequence of data flanks or to the clock flank from the sequence of clock flanks; and
- means for recording the at least one sample value with the data flank and the clock flank in the common block of the digital data memory in real time.

9. Device according to Patent Claim 8, in which the sequence of data flanks and the sequence of clock flanks are respectively represented by a sequence of time stamps.

10. Device according to Patent Claim 9, in which the assignment is performed with the aid of the respective time stamp.

11. Device according to Patent Claim 7, in which the common block of the digital data memory is a logic memory side of a side-oriented virtual memory.

12. Device according to Patent Claim 7, in which the clock recovery block (640) for determining a sequence of clock flanks from the data signal in real time further comprises:

- means for cleaning the data signal around a trend;
- means for filtering the cleaned data signal in order to obtain a cleaned sequence of clock flanks.

**Revendications**

1. Procédé d'enregistrement de données de gigue, comportant les étapes de :

- détermination (210) d'une séquence de fronts de données à partir d'un signal de données en temps réel ;
- détermination (220) d'une séquence de fronts d'horloge à partir du signal de données en temps réel ;

**caractérisé par** les étapes suivantes :

- l'association (230) d'au moins un front d'horloge provenant de la séquence de fronts d'horloge à au moins un front de données provenant de la séquence de fronts de données, dans laquelle la séquence de fronts de données est ralentie, afin d'atteindre une synchronisation approximative avec la séquence de fronts de horloge ;
- l'enregistrement (240) du au moins un front de données et du au moins un front d'horloge associés dans un bloc commun d'une mémoire de données numérique en temps réel.

2. Procédé selon la revendication 1, comportant en outre les étapes consistant à :

- déterminer (305) une séquence de valeurs échantillons du signal de données en temps réel ;
- associer (335) au moins une valeur échantillon au front de données provenant de la séquence de fronts de données ou au front d'horloge provenant de la séquence de fronts d'horloge ; et
- enregistrer (340) la au moins une valeur échantillon avec le front de données et le front d'horloge dans le bloc commun de la mémoire de données numérique en temps réel.

3. Procédé selon la revendication 1, dans lequel la séquence de fronts de données et la séquence de fronts d'horloge sont représentées respectivement par une séquence d'horodateurs.

4. Procédé selon la revendication 3, dans lequel l'association est effectuée en regard de l'horodateur respectif.

5. Procédé selon la revendication 2, dans lequel la séquence de valeurs échantillons est ralentie, afin d'atteindre une synchronisation avec la séquence de fronts d'horloge.

6. Procédé selon la revendication 1, dans lequel l'étape de détermination (220) d'une séquence de fronts d'horloge à partir du signal de données en temps réel comporte en outre les étapes consistant à :

- nettoyer le signal de données d'une tendance ;
- filtrer le signal de données nettoyées, afin d'obtenir une séquence nettoyée de fronts d'horloge.

**7.** Dispositif d'enregistrement de données de gigue, comportant :

- un enregistreur de signal (620) pour enregistrer un signal de données binaire (610) ;
- un bloc de reconnaissance de front (630) pour déterminer une séquence de fronts de données à partir du signal de données en temps réel ;
- un bloc de récupération d'horloge (640) pour déterminer une séquence de fronts d'horloge à partir du signal de données en temps réel ;

**caractérisé par**

- un bloc d'association (650) pour associer au moins un front d'horloge provenant de la séquence de fronts d'horloge à un front de données provenant de la séquence de fronts de données, dans lequel la séquence de fronts de données est ralentie par un bloc FIFO, afin d'atteindre une synchronisation approximative d'une séquence de fronts d'horloge ;
- un bloc d'enregistrement (650) pour enregistrer le front de données et le au moins un front d'horloge associé dans un bloc commun d'une mémoire de données numérique (660) en temps réel.

**8.** Dispositif selon la revendication 7, comportant en outre :

- un moyen pour déterminer une séquence de valeur échantillon du signal de données en temps réel ;
- un moyen pour associer au moins une valeur échantillon au front de données provenant de la séquence de fronts de données ou au front d'horloge provenant de la séquence de fronts d'horloge ; et
- un moyen pour enregistrer l'échantillon avec le front de données et le front d'horloge dans le bloc commun de la mémoire de données numérique en temps réel.

**9.** Dispositif selon la revendication 8, dans lequel la séquence de fronts de données et la séquence de fronts d'horloge sont représentées respectivement par une séquence d'horodateurs.

**10.** Dispositif selon la revendication 9, dans lequel l'association est effectuée en regard de l'horodateur respectif.

**11.** Dispositif selon la revendication 7, dans lequel le bloc commun dans la mémoire de données numérique est une page de mémoire logique d'une mémoire virtuelle paginée.

**12.** Dispositif selon la revendication 7, dans lequel le bloc de récupération d'horloge (640) pour déterminer une séquence de fronts d'horloge à partir du signal de données en temps réel comporte en outre :

- un moyen pour nettoyer le signal de données d'une tendance ;
- un moyen pour filtrer le signal de données nettoyées, pour obtenir une séquence nettoyée de fronts d'horloge.

Fig. 1

EP 2 191 606 B1

Start

| Daten-flanken |—210

| Takt-flanken |—220

| Zu-ordnung |—230

| Speichern |—240

200

Stop

**Fig. 2**

Start

| Abtast-werte |—305

| Daten-flanken |—310

| Takt-flanken |—320

| Zu-ordnen |—330

| Zu-ordnen |—335

| Speichern |—340

300

Stop

**Fig. 3**

Phasendetektor

$|e(k)| < T_0/2$

NO

$0 \rightarrow$

MUX

YES

$x_0(k)$

$+$

$-$

$e(k)$

Schleifenfilter

$F(q^{-1})$

Nominale
Bitperiode

$T_0$

$y(k)$

$A(q^{-1})$

Akkumulator

**Fig. 4**

$x(k)$

$+$

$-$

$\tilde{x}(k)$

$A(q^{-1})$

$T_0$

520

$+$

$-$

$e(k)$

$F(q^{-1})$

530

$A(q^{-1})$

540

$\tilde{y}(k)$

550

$A(q^{-1})$

$T_0$

560

$y(k)$

**Fig. 5**

Fig. 6

Fig. 7

$K_1$ Bits    $K_2$ Bits    $K_3$ Bits

| Abtastwerte | Datenflanken | Taktflanken |

Daten zum
(n-1)-ten Zeitfenster

Daten zum n-ten Zeitfenster

Daten zum
(n+1)-ten Zeitfenster

## Fig. 8

$N_1$ Bits    $N_2$ Bits

Zeitstempel

| Grobauflösung | Feinauflösung |

$M_1$ Bits

Fensterposition

$\oplus$

Versatz
im Fenster

$M_2$ Bits

## Fig. 9

**IN DER BESCHREIBUNG AUFGEFÜHRTE DOKUMENTE**

**In der Beschreibung aufgeführte Patentdokumente**

- US 5469466 A

**In der Beschreibung aufgeführte Nicht-Patentliteratur**

- **K. PARHI ; D. MESSERSCHMITT.** Pipeline Interleaving and Parallelism in Recursive Digital Filters - Part I: Pipelining Using Scattered Look-Ahead and Decomposition'' und ''Pipeline Interleaving and Parallelism in Recursive Digital Filters - Part II: Pipelined Incremental Block Filtering. *IEEE Transactions on Acoustics, Speech and Signal Processing,* Juli 1989, vol. 37 (7), 1099-11171118-1134